# EUROPEAN PATENT APPLICATION

(11) **EP 4 819 771 A1**
(43) Date of publication of application: **07.10.2026**
(21) Application number: 25167385.1
(22) Date of filing: 31.03.2025
(51) Int. Cl.: H05K 1/14, H05K 1/02, H05K 3/34

(54) **VERTICAL POWER DELIVERY PACKAGE**

(71) Applicant: Photeon Technologies GmbH, 6850 Dornbirn (AT)
(72) Inventor: Morris, Tim, 6850 Dornbirn (AT); Schneider, Andreas, 6850 Dornbirn (AT)
(74) Representative: Gangl, Markus

(57) **Abstract**

A vertical power package for delivering power to at least one processing unit (4), the vertical power package comprising at least one integrated voltage regulator having a first side (2) and a second side (3), the at least one integrated voltage regulator being configured to be mounted on its first side (2) to a printed circuit board (1) by at least one soldered pad (5, 6) and, on its second side (3), having at least one soldered pad (5, 6, 7) which is configured to mount at least one processing unit (4) in order to deliver power, and an arrangement comprising a substrate (8) carrying at least one processing unit (4) and a vertical power package as described above, the substrate (8) being arranged on the printed circuit board (1) of the vertical power package and the at least one processing unit (4) being mounted to the second side (3) of the at least one integrated voltage regulator of the vertical power package.

## Description

The disclosure is in the field of vertical power delivery to processing units.

It is known to use integrated voltage regulators (IVR) on a printed circuit board to provide power to processing units with a defined, stable voltage, including the possibility of a change of voltage.

It is known to do vertical power delivery by using a ball grid array (BGA), which is a grid array of solder balls. A known problem of a BGA is the electromigration limit which limits the power that can be delivered through a BGA.

A vertical power delivery package using a BGA for power delivery is shown in US 11,799,374 B2.

It is an object of a vertical power delivery package of the disclosure to circumvent the electromigration limit of a BGA and to provide an arrangement comprising a substrate carrying at least one processing unit and at least one such vertical power delivery package.

This object is being achieved by a power delivery package having the features of claim 1 and an arrangement having the features of claim 11.

A vertical power package for delivering power to at least one processing unit comprises at least one integrated voltage regulator having a first side and a second side, the at least one integrated voltage regulator being configured to be mounted on its first side to a printed circuit board by at least one soldered pad and, on its second side, having at least one soldered pad which is configured to mount at least one processing unit in order to deliver power.

An arrangement comprises at least:
- a substrate carrying at least one processing unit
- a vertical power package comprising a printed circuit board on which are arranged at least:
   - at least one ball grid array
   - at least one integrated voltage regulator having a first side and a second side, the at least one integrated voltage regulator being mounted on its first side to the printed circuit board by at least two soldered pads and, on its second side, having at least two soldered pads which are configured to mount a processing unit in order to deliver power
the substrate being arranged on the printed circuit board of the vertical power package and the at least one processing unit being mounted to the second side of the at least one integrated voltage regulator of the vertical power package

The use of soldered pads to conduct power into the at least one IVR and, from the at least one IVR, to the at least one processing unit avoids the problem of the electromigration limit of a BGA because other than a ball a pad has a larger surface to transfer power. Higher powers can be transmitted which is particularly relevant with respect to Artificial Intelligence applications of the at least one processing unit. If there is a BGA present, it can still be used for other purposes than transferring the main power of the at least one processing unit, e.g. for the transfer of signals and/or for mechanically mounting the at least one processing unit.

By way of example, it can be arranged that during operation an input voltage of 2 Volt and current 500 Ampere is provided to the at least one IVR and for delivery to the at least one processing unit the voltage is converted by the at least one IVR into 0.8 Volt with a current of 1250 Ampere.

Embodiments are defined in dependent claims.

In some embodiments the integrated voltage regulator has, on its first side and/or on its second side, at least one soldered input pad and/or at least one soldered ground pad.

In some embodiments, on the second side of the integrated voltage regulator, the at least one soldered output power pad is surrounded by a soldered ground pad and/or at least two soldered input power pads are arranged at sides of the at least one soldered output power pad.

In some embodiments between the first side and the second side of the integrated voltage regulator, the at least one soldered ground pad and/or at least one soldered input power pad are connected using vias which can be made of copper or another electrically conducting material.

In some embodiments the package further comprises a printed circuit board on which the at least one integrated voltage regulator is mounted by its first side.

In some embodiments there is a plurality of integrated voltage regulators.

In some embodiments the at least one integrated voltage regulator has, on its first side and on its second side, at least one soldered input power pad and/or at least one soldered ground pad.

In some embodiments the at least one integrated voltage regulator has, on its second side, at least one soldered output power pad.

In some embodiments, on the second side of the at least one integrated voltage regulator, the at least one soldered output power pad is surrounded by a soldered ground pad and/or at least two soldered input power pads are arranged at sides of the at least one soldered output power pad.

In some embodiments the at least one integrated voltage regulator has:
- on its first side at least one soldered input power pad through which the current enters the at least one integrated voltage regulator
- on its second side at least one soldered output power pad
and the current flows to at least one processing unit mounted to the second side of the at least one integrated voltage regulator through the at least one soldered input power pad and the at least one soldered output pad, and the electrical current is closed by
- at least one soldered ground pad, and/or
- at least part of the at least one ball grid array

This can be applied to at least one integrated voltage regulator in the form of a linear regulator or a DC-DC converter.

In some embodiments the at least one integrated voltage regulator has:
- on its second side at least one soldered ground pad, and
- at least one soldered output power pad
and current can flow into the at least one soldered ground pad and out of the at least one soldered output pad This can be applied to at least one integrated voltage regulator in the form of a DC-DC converter.

In some embodiments the at least one ball grid array surrounds the at least one integrated voltage regulator. Optionally, in the case of the presence of several integrated voltage regulators, the at least one ball grid array can also be present between the integrated voltage regulators.

In some embodiments the at least one ball grid array is connected to a bus. In such embodiments the at least one ball grid array can be used to transfer signals to and/or from the at least one processing unit and/or to close the circuit.

In some embodiments the at least one ball grid array is a wide-pitch ball grid array.

In some embodiments at least two integrated voltage regulators are arranged side-by-side, possibly with at least one ball grid array between them.

In some embodiments the at least one soldered input power pad and/or the at least one soldered ground pad and/or at least one other soldered pad are configured to transfer heat into the printed circuit board.

In some embodiments of the arrangement the at least one processing unit is connected to the second side of the at least one integrated voltage regulator by a fine-pitch ball grid array. A fine-pitch ball grid array is mainly used in system-on-a-chip (SOC) designs. The fine pitch ball grid array (JEDEC-Standard) is also known as fine line BGA by Altera.

In some embodiments of the arrangement the substrate carrying the at least one processing unit is a SOC.

In some embodiments, also of the arrangement, the distance between the first side and the second side is equal to or less a distance between the printed circuit and the substrate after soldering the BGA.

Two or more of the embodiments described above can be combined.

Embodiments are discussed having regard to the Figures.
Figure 1 shows a detail of an arrangement including a vertical power package.
Figure 2 shows the arrangement of which a detail in shown in Figure 1 in full.
Figure 3 shows a top view of a vertical power package showing surface plated copper pads.
Figure 4 shows a top view of the vertical power package of Figure 3 showing a copper redistribution layer beneath the exposed copper pads.
Figure 5 shows a top view of the vertical power package of Figures 3 and 4 showing copper vias and a surface plated copper which, actually, is arranged on a bottom side of the vertical power package.
Figure 6 shows a top view of the vertical power package of Figure 3 - 5 showing multiple package layers.
Figure 7 shows a side view of the vertical power package of Figure 3 - 6 showing multiple package layers.
Figure 8 shows a bottom view of the vertical power package of Figure 3 - 7 showing multiple package layers.

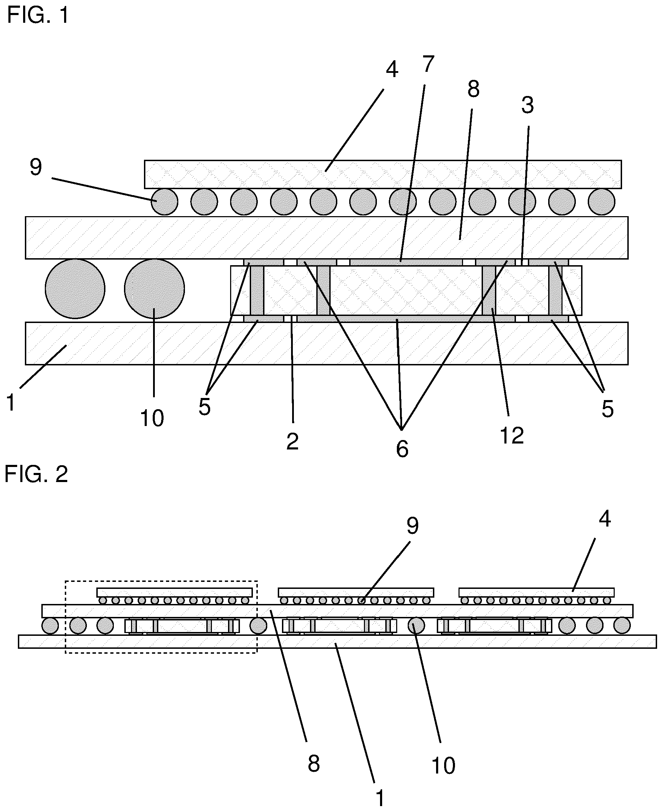

Figures 1 and 2 show an arrangement comprising a substrate carrying several processing units 4 and a vertical power package comprising a printed circuit board 1 on which are arranged one wide-pitch ball grid array 10 and several integrated voltage regulators, each integrated voltage regulator having a first side 2 and a second side 3, the integrated voltage regulators being mounted on their first sides 2 to the printed circuit board 1 by soldered input power pads 5 and a soldered ground pad 6 and, on their second sides 3, having soldered input power pads 5, a soldered ground pad 6 and a soldered output power pad 7, the soldered power pads 5, 6, 7 mounting a substrate 8 carrying the processing units 4 in order to deliver power. Vias 12 which connect soldered power pads 5, 6 which are present, both, on the first side 2 and the second side 3 can be seen.

The wide-pitch ball grid array 10 surrounds the integrated voltage regulators and, in the shown embodiment, is also present between the integrated voltage regulators.

The processing units 4 are mounted to the substrate 8 by way of a fine-pitch ball grid array 9.

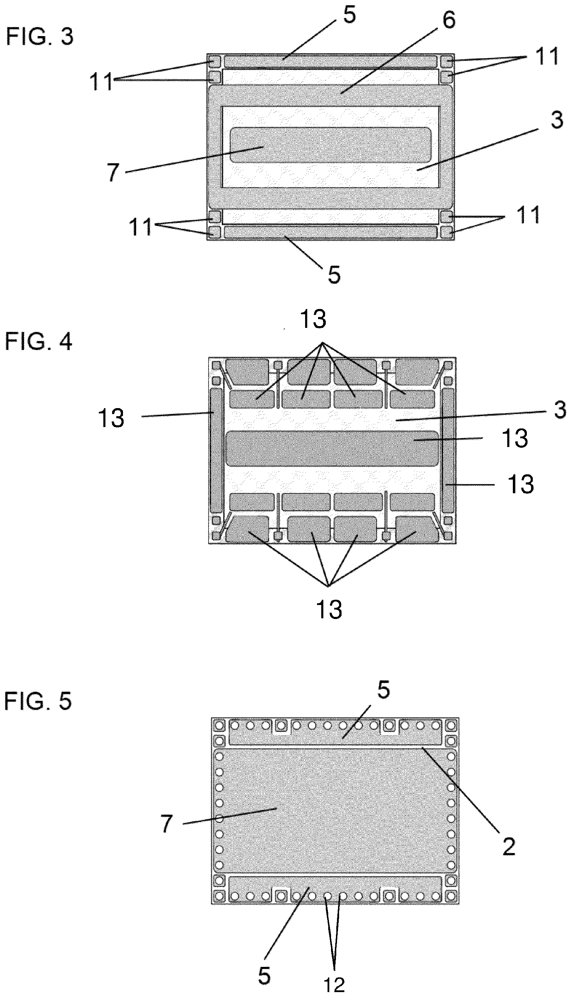

In Figure 3 copper plated interface pins 11 can be seen.

In Figure 4 redistribution structures 13 can be seen.

In Figure 5 the vias 12 (the white circles) can be seen from a different perspective. Note, that not all of the vias 12 have been provided with reference numbers.

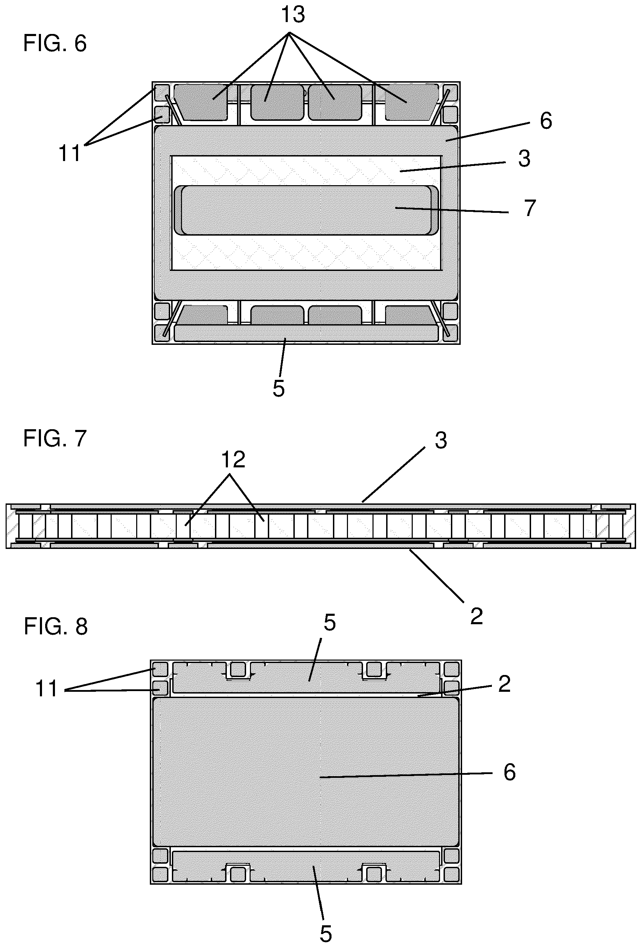

In Figure 6 the bar-shaped input power pad 5 which can be seen at the lower side of the Figure is actually also present on the upper side of the Figure but has been removed there to allow a view of the lower structure.

### List of reference signs:

- 1: printed circuit board
- 2: first side of integrated voltage regulator
- 3: second side of integrated voltage regulator
- 4: processing unit
- 5: soldered input power pad
- 6: soldered ground pad
- 7: soldered output power pad
- 8: substrate
- 9: wide-pitch ball grid array
- 10: fine-pitch ball grid array
- 11: interface pin
- 12: via
- 13: redistribution structure

## Claims

1. A vertical power package for delivering power to at least one processing unit (4), the vertical power package comprising at least one integrated voltage regulator having a first side (2) and a second side (3), the at least one integrated voltage regulator being configured to be mounted on its first side (2) to a printed circuit board (1) by at least one soldered pad (5, 6) and, on its second side (3), having at least one soldered pad (5, 6, 7) which is configured to mount at least one processing unit (4) in order to deliver power.

2. The package of the preceding claim wherein the integrated voltage regulator has, on its first side and/or on its second side, at least one soldered input pad (5) and/or at least one soldered ground pad (6).

3. The package of the preceding claim wherein, on the second side (3) of the integrated voltage regulator, the at least one soldered output power pad (7) is surrounded by a soldered ground pad (6) and/or at least two soldered input power pads (5) are arranged at sides of the at least one soldered output power pad (7).

4. The package of the preceding claim wherein, between the first side (2) and the second side (3) of the integrated voltage regulator, the at least one soldered ground pad (6) and/or at least one soldered input power pad (5) are connected using vias (12) which can be made of copper or another electrically conducting material.

5. The package of at least one of the preceding claims wherein the package further comprises a printed circuit board (1) on which the at least one integrated voltage regulator is mounted by its first side (2).

6. The package of the preceding claim wherein there is a plurality of integrated voltage regulators.

7. The package of at least one of the preceding claims wherein the at least one ball grid array (10) surrounds the at least one integrated voltage regulator.

8. The package of at least one of the three preceding claims wherein the package further comprises at least one ball grid array (9, 10) mounted to the printed circuit board (1) and wherein, preferably, the at least one ball grid array (9, 10) is a wide-pitch ball grid array (10).

9. The package of at least one of the preceding claims wherein at least two integrated voltage regulators are arranged side-by-side, possibly with at least one ball grid array (10) between them.

10. The package of at least one of the preceding claims wherein the at least one soldered input power pad (5) and/or the at least one soldered ground pad (6) and/or at least one other soldered pad are configured to transfer heat into the printed circuit board (1).

11. An arrangement comprising at least:
- a substrate (8) carrying at least one processing unit (4)
- a vertical power package according to at least one of the preceding claims the substrate (8) being arranged on the printed circuit board (1) of the vertical power package and the at least one processing unit (4) being mounted to the second side (3) of the at least one integrated voltage regulator of the vertical power package.

12. The arrangement of the preceding claim wherein the at least one processing unit (4) is mounted to the second side (3) of the at least one integrated voltage regulator by a fine-pitch ball grid array (9).

13. The arrangement of one of the two preceding claims wherein the substrate (8) carrying the at least one processing unit (4) is a SOC.

14. The arrangement of at least one of the three preceding claims wherein the at least one integrated voltage regulator has:
- on its first side (2) at least one soldered input power pad (5) through which the current enters the at least one integrated voltage regulator
- on its second side (3) at least one soldered output power pad (7) and the current flows to at least one processing unit (4) mounted to the second side (3) of the at least one integrated voltage regulator through the at least one soldered input power (5) pad and the at least one soldered output pad (7), and the electrical current is closed by
- at least one soldered ground pad (6), and/or
- at least part of the at least one ball grid array (9, 10)

15. The arrangement of at least one of the four preceding claims wherein the at least one integrated voltage regulator has on its second side (3):
- at least one soldered ground pad (6), and
- at least one soldered output power pad (7)
and current can flow into the at least one soldered ground pad (6) and out of the at least one soldered output pad (7).
